# FASCICULE DE BREVET EUROPEEN

(11) **EP 0 828 413 B1**
(45) Date de publication et mention de la délivrance du brevet: **23.07.2003**
(21) Numéro de dépôt: 97114987.7
(22) Date de dépôt: 29.08.1997
(51) Int. Cl.: H05K 13/00, H01R 12/08

(54) **Dispositif d'affichage électro-optique et support flexible pour de tels dispositifs servant à l'alimentation de ces dispositifs**
Elektro-optische Anzeigeeinrichtung und flexibler Träger für solche Einrichtungen zur Stromversorgung dieser Einrichtungen
Electro-optical display and flexible support for devices like this to be used for electrical supply for the displays

(30) Priorité: 04.09.1996 FR 9610764
(43) Date de publication de la demande: 11.03.1998
(73) Titulaire: Omega Electronics S.A., 2500 Bienne (CH)
(72) Inventeur: Klappert, Rolf, 2003 Neuchâtel (CH); Desarzens, Pierre, 2503 Bienne (CH)
(74) Mandataire: Balsters, Robert

(56) Documents cités:
- EP-A- 0 075 213
- DE-A- 4 214 384
- FR-A- 2 611 189

## Description

La présente invention concerne des dispositifs d'affichage électro-optique, notamment à cristal liquide, comprenant au moins un module d'affichage comportant au moins un ensemble électro-optique et des moyens d'alimentation de cet ensemble.

En particulier, l'invention concerne les moyens d'alimentation d'une ou plusieurs unité(s) active(s) d'un ou plusieurs ensemble(s) électro-optique(s). La présente invention concerne aussi plus spécifiquement des moyens d'alimentation pour dispositifs d'affichage électro-optique assurant des liaisons électriques entre une source ou unité d'alimentation et un ou plusieurs ensemble(s) électro-optique(s). La présente invention concerne plus particulièrement les dispositifs d'affichage électro-optique de grandes dimensions, à savoir ayant des dimensions de l'ordre de plusieurs centimètres, mais elle n'est pas limitée au dispositif d'affichage électro-optique ayant de telles dimensions.

Il est connu des dispositifs d'affichage électro-optique comprenant un module d'affichage comportant une cellule électro-optique formée de premier et deuxième substrats transparents entre lesquels est prévu une couche de cristal liquide. Des électrodes et contre-électrodes sont prévues sur les faces internes desdits premier et deuxième substrats transparents. Ces électrodes et contre-électrodes déposées sur les premier et deuxième substrats transparents sont reliées par des pistes d'alimentation électrique à une source ou unité d'alimentation du module d'affichage électro-optique. Ces pistes d'alimentation électrique sont déposées directement sur l'une ou l'autre des deux substrats transparents et sont formées par un matériau transparent connu de l'homme du métier. Cependant, ces pistes d'alimentation électrique transparentes déposées directement sur le substrat nécessite des largeurs relativement grandes pour permettre le passage d'un signal électrique d'une intensité suffisante pour commander plusieurs unités de gestion de l'alimentation des diverses unités actives.

Par contre, les pistes reliant les unités de gestion de l'alimentation à une ou plusieurs unité(s) active(s) peuvent être relativement minces étant donné qu'elles ne doivent transporter que de faibles courants d'alimentation, alors que les pistes reliant les diverses unités de gestion susmentionnées à une source d'alimentation doivent être bien plus larges pour pouvoir conduire des courants électriques d'une intensité suffisante avec les matériaux connus pour la fabrication de pistes transparentes.

Ainsi, les dimensions du module électro-optique doivent être suffisantes pour permettre l'agencement des pistes d'alimentation électrique reliant les unités de gestion susmentionnées à une source d'alimentation. De plus, l'agencement de ces unités de gestion sur la surface d'un des substrats de l'ensemble électro-optique est une opération délicate et onéreuse en temps et en matériel nécessitant de plus le maniement du substrat qui reçoit les unités de gestion, lequel est encombrant lorsque le module électro-optique fabriqué comprend au moins un ensemble électro-optique de grandes dimensions.

Un but de la présente invention est donc de fournir un dispositif d'affichage électro-optique pouvant être fabriqué aisément pour un coût de fabrication moindre que celui de la fabrication des dispositifs d'affichage électro-optique de l'art antérieur décrits ci-avant.

Un autre but de l'invention est de réduire les dimensions du module d'affichage électro-optique pour une cellule électro-optique ayant des dimensions déterminées.

Un autre but de l'invention est de réduire les dimensions du substrat sur lequel sont déposés les électrodes d'une ou plusieurs unité(s) active(s) d'un ensemble électro-optique de dimensions déterminées.

Un autre but de l'invention est de fournir des moyens de liaisons électrique entre l'ensemble électro-optique et une source d'alimentation qui sont peu onéreux, aisés à fabriquer et permettant une production automatisée en continu de modules d'affichage électro-optique.

D'autres buts de la présente invention apparaîtront également à la lecture de la description qui suit.

La présente invention a pour objet un dispositif d'affichage électro-optique comportant au moins un module d'affichage comprenant au moins un ensemble électro-optique qui comprend au moins deux unités actives et des moyens d'alimentation de cet ensemble. Ce dispositif d'affichage est caractérisé en ce que les moyens d'alimentation comprennent un support flexible allongé sur lequel des pistes métallisées de connexion électrique sont agencées pour relier lesdites au moins deux unités actives à une unité d'alimentation des moyens d'alimentation. Le support flexible allongé est assemblé à l'ensemble électro-optique et présente au moins une partie intermédiaire lâche située entre deux ensembles de plages de connexion électrique reliées aux pistes d'alimentation desdites unités actives.

Grâce aux caractéristiques de l'objet de l'invention décrit ci-dessus, il est possible de fabriquer des modules d'affichage pour un prix avantageux tout en assurant une excellente alimentation électrique de la ou des unité(s) active(s). En effet, la présence d'une ou plusieurs partie(s) intermédiaire(s) lâche(s) située(s) entre deux ou plusieurs ensembles de plages de connexion électrique connectées à des plages de connexion électrique correspondantes de l'ensemble électro-optique lui-même permet de garantir un alignement précis de chacun de ces ensembles de plages de connexion du support flexible avec lesdits ensembles de plages de connexion correspondants. On notera que les plages de connexion électrique peuvent être constituées simplement par l'extrémité de pistes de conduction électrique.

En particulier pour les modules d'affichage électro-optique de grandes dimensions, la différence de nature des matériaux en présence, les tolérances de fabrication des pistes de conduction électrique et les tolérances d'assemblage de l'ensemble électro-optique avec le support flexible ne permettent pas d'assurer sur une distance relativement grande un alignement correct de toutes les plages de connexion électrique entre le support flexible et l'ensemble électro-optique lorsque le support flexible est relié fixement à l'ensemble électro-optique sur toute sa longueur comme cela serait le cas en l'absence des parties intermédiaires lâches prévues dans le cadre de la présente invention. Ces parties intermédiaires lâches sont d'autant plus nécessaire pour assurer une précision de positionnement des ensembles de plages de connexion électrique étant donné que le support flexible et l'ensemble électro-optique auquel il est destiné sont assemblés généralement soit par collage à chaud, soit par soudage. Il résulte de cette opération des tensions thermo-mécaniques ayant tendance à déformer en partie le support flexible allongé. Grâce aux parties intermédiaires lâches prévues, il est possible de positionner le support flexible allongé par section, c'est-à-dire de positionner indépendamment chaque partie située d'un côté ou de l'autre d'une partie intermédiaire lâche.

Selon un premier mode de réalisation, la partie intermédiaire lâche est formée par un pli du support flexible allongé.

A titre d'exemple, le support flexible allongé est formé par un matériau en polyester ou en polyimide.

L'invention a également pour objet un support flexible pour dispositif d'affichage électro-optique servant à relier électriquement au moins une unité active d'au moins un ensemble électro-optique à une unité d'alimentation de ce dispositif d'affichage. Ce support flexible présente sur au moins une de ses surfaces des pistes métallisées s'étendant selon la direction longitudinale de ce support flexible et destinées à être connectées électriquement à une unité d'alimentation. Ce support flexible présente des parties intermédiaires, entre des parties destinées à assurer des connexions électriques avec lesdites unités actives, où lesdites pistes métallisées présentent un écartement supérieur à l'écartement de ces pistes métallisées dans lesdites parties destinées à assurer des connexions électriques avec ladite au moins une unité active.

Le support flexible, objet de la présente invention, peut être utilisé dans la fabrication des dispositifs d'affichage selon l'invention. Le fait que les pistes métallisées présentent dans les parties intermédiaires un écartement supérieur à l'écartement de ces pistes métallisées dans les parties destinées à assurer des connexions électriques avec l'ensemble électro-optique permet, après sectionnement du support flexible dans une de ces régions intermédiaires, d'agencer un connecteur permettant de connecter des modules électro-optiques entre eux et également de connecter chaque module électro-optique à une unité d'alimentation du dispositif d'affichage.

Selon une caractéristique particulière de l'invention, les pistes métallisées dans les parties intermédiaires présentent une largeur supérieure à la largeur de ces pistes métallisées dans les parties destinées à assurer des connexions électriques avec les unités actives. De ce fait, la fiabilité de l'alimentation électrique est augmentée étant donné que ces parties intermédiaires sont destinées à former les parties intermédiaires lâches, notamment sous forme de plis, une fois le support flexible assemblé à un ensemble électro-optique pour former un dispositif d'affichage selon l'invention. En effet, ces parties intermédiaires lâches présentent une ondulation dans le mode de réalisation proposé ci-après et peuvent être soumises à des contraintes mécaniques supérieures aux autres parties du support flexible. De plus, après sectionnement transversal du support flexible, il est aisé d'agencer un connecteur à l'une ou l'autre des deux extrémités résultantes, les plages de connexion électrique étant déjà agencées sur le support flexible.

Il résulte de l'agencement particulier du support flexible qu'il est possible de fournir ce support flexible sous la forme d'une bande continue destinée à être sectionnée lors de la fabrication de dispositifs d'affichage électro-optique de manière à obtenir des tronçons de longueurs quelconques prédéterminées destinés à autant de modules électro-optiques formant ces dispositifs d'affichage.

La présente invention sera décrite plus particulièrement à l'aide de la description suivante, faite en référence aux dessins annexés donnés à titre d'exemples nullement limitatifs, dans lesquels :
- la figure 1 représente une vue schématique en perspective d'un module électro-optique destiné à un dispositif d'affichage électro-optique selon l'invention;
- la figure 2 est une vue en coupe selon la ligne de coupe II-II de la figure 1;
- la figure 3 est une vue schématique en plan correspondant à une vue partielle de dessous de la figure 1;
- la figure 4 est une vue en coupe selon la ligne de coupe IV-IV de la figure 1, et
- la figure 5 est une vue schématique de dessus d'un support flexible allongé.

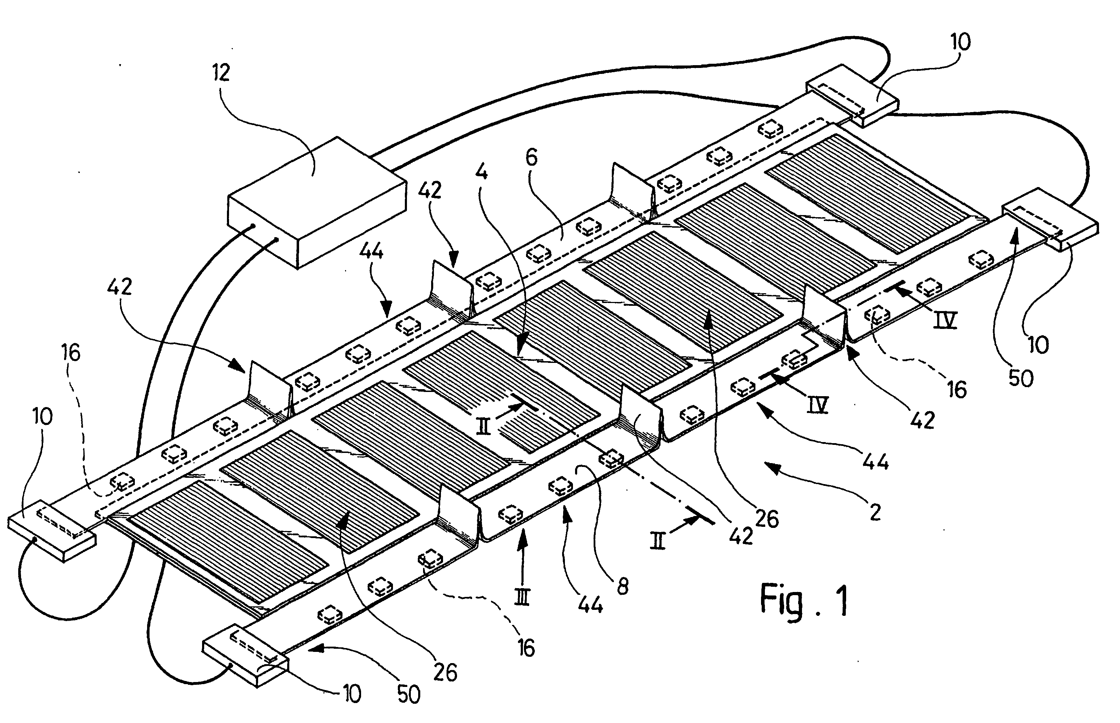

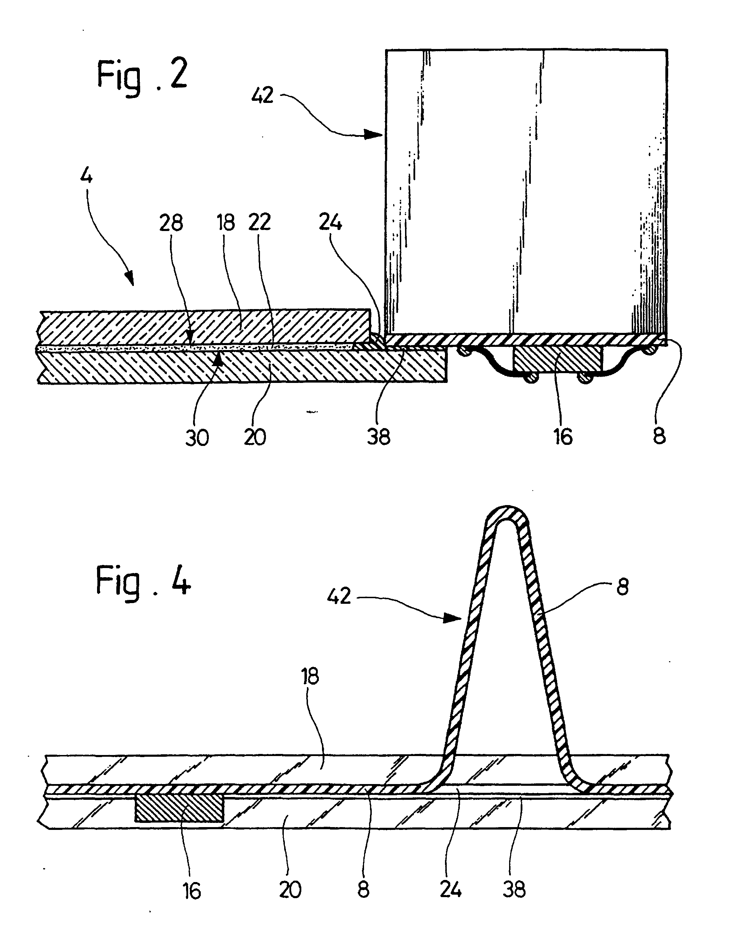

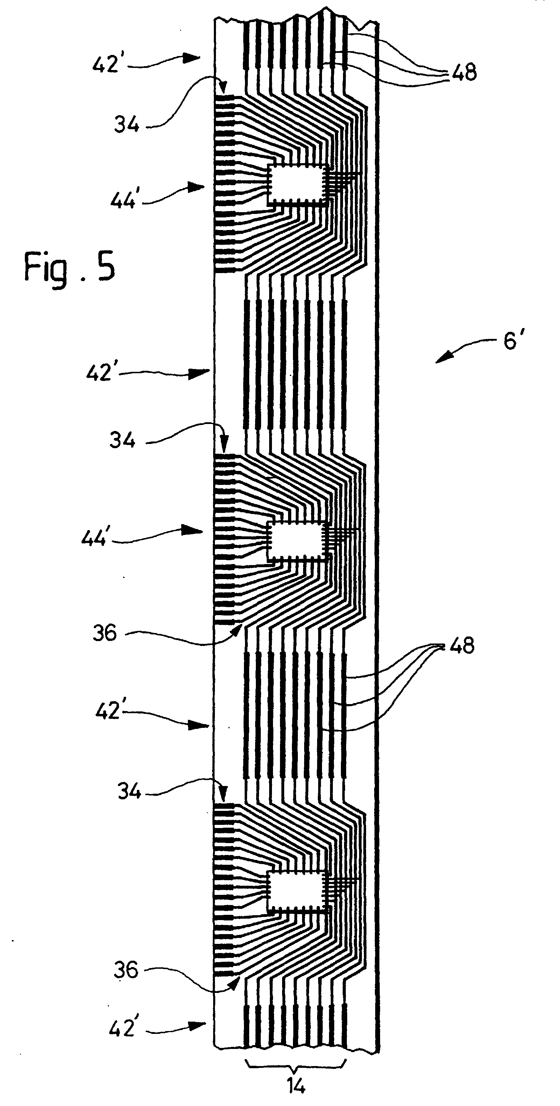

On décrira ci-après, à l'aide des figures 1 à 4, un mode de réalisation d'un dispositif d'affichage électro-optique selon l'invention.

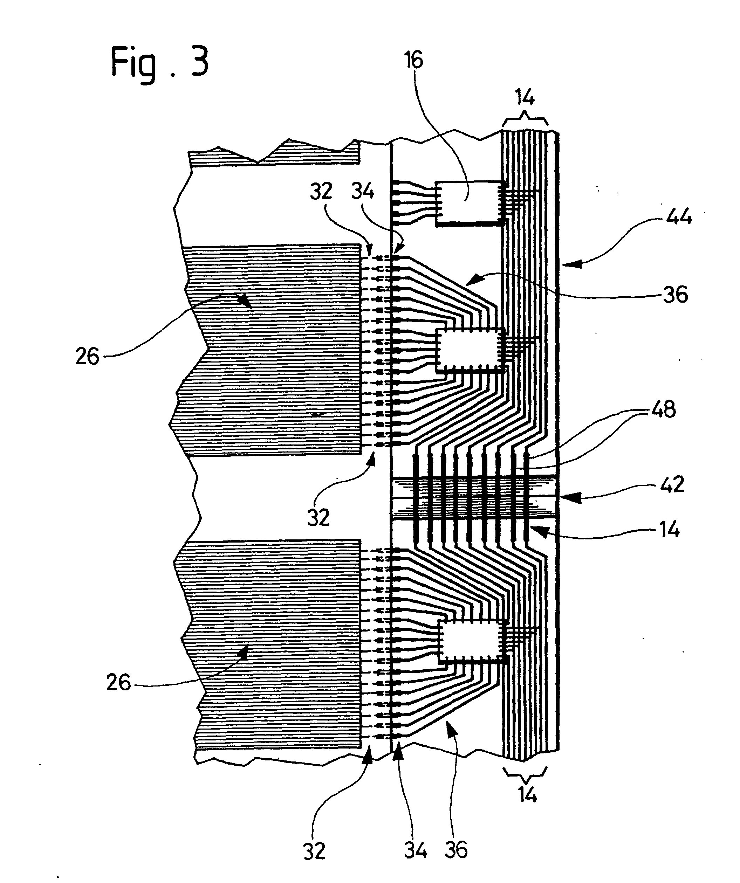

Sur la figure 1 est représenté schématiquement un module d'affichage électro-optique 2. On mentionnera que le dessin est schématique et que le module d'affichage peut comprendre d'autres éléments supplémentaires, notamment un boîtier. Le module 2 comprend une cellule électro-optique 4 et des moyens d'alimentation de cette cellule électro-optique 4 comprenant deux supports flexibles allongés 6 et 8, des connecteurs 10 et une unité d'alimentation 12 reliée électriquement aux connecteurs 10. Ces connecteurs 10 servent à relier électriquement des pistes métallisées 14 (figure 3) agencées sur au moins une surface de chacun des deux supports flexible 6 et 8.

Sur les supports flexible 6 et 8 sont agencés des circuits intégrés 16. Ces circuits intégrés 16 sont reliés électriquement aux pistes métallisées 14. La cellule électro-optique 4 est formée de deux plaques de verre 18 et 20 entre lesquelles est prévu un cristal liquide 22. Le logement formé entre les plaques de verre 18 et 20 pour le cristal liquide 22 est fermé au moyen d'une colle 24 de manière classique. On notera que les plaques peuvent aussi être par exemple en plastique.

La cellule électro-optique 4 comprend une pluralité d'unités actives 26. Chacune de ces unités actives 26 est reliée électriquement à un ou plusieurs circuits intégrés 16 au moyen d'un ensemble de pistes 32 agencées sur l'une ou l'autre des surfaces 28 et 30 des plaques de verre respectives 18 et 20. Cet ensemble de pistes 32, généralement formé à l'aide d'un matériau transparent connu de l'homme du métier, est connecté à un ensemble de plages de connexion électrique respectives 34 agencées sur chacun des supports flexibles 6 et 8. Ces ensembles de plages de connexion électrique 34 sont formés par métallisation sur le support flexible 6, respectivement 8 et sont reliés chacun à l'un ou l'autre des circuits intégrés 16 à l'aide des pistes métallisées 36 agencées sur le support 6, respectivement 8. La connexion électrique entre les pistes 32 déposées sur le verre et les plages de connexion 34 agencées sur le support flexible 6 ou 8 peut se faire par collage ou par soudage.

Dans le présent cas, les supports flexibles 6 et 8 sont reliés mécaniquement et électriquement à la cellule électro-optique 4 au moyen d'une colle conductrice anisotrope 38 connue de l'homme du métier. Lorsque l'extrémité des pistes 32 sont superposées aux plages de connexion électrique 34, un contact électrique est établi entre ces pistes 32 et ces plages de connexion 34 au moyen de la colle conductrice anisotrope 38. Ainsi, il est nécessaire d'avoir un alignement de précision entre les extrémités des pistes 32 de la cellule électro-optique 4 et les plages de connexion électrique 34 du support flexible 6, respectivement 8.

Les unités actives 26 sont formées généralement d'une pluralité d'électrodes dont la majorité sont adressées de manière individuelle. La connexion entre la pluralité d'électrodes (et également de contre-électrodes) et les circuits intégrés 16 pour effectuer cet adressage permet d'afficher différentes informations données. Les liaisons électriques entre la pluralité d'électrodes et de contre-électrodes de chacune des unités actives 26 au(x) circuit(s) intégré(s) 16 est réalisé à l'aide des pistes d'alimentation 32 de la cellule 4 et des pistes 36 métallisées sur le support flexible 6, respectivement 8, lesquels se terminent par un ensemble de plages de connexion électrique 34 qui doivent être alignées sur les extrémités des pistes d'alimentation respectives 32 pour assurer les connexions électriques entre cette unité active 26 et le ou les circuit(s) intégré(s) 16.

Etant donné la pluralité d'électrodes et de contre-électrodes de chaque unité active 26, la densité des extrémités des pistes d'alimentation 32 et la densité des plages de connexion électrique 34 correspondante sont généralement élevées. Or, lors de l'assemblage des supports flexibles 6 et 8 à la plaque de verre 20 de la cellule électro-optique 4, il est difficile d'assurer un alignement correct des extrémités des pistes d'alimentation 32 avec les ensembles de plages de connexion électriques 34 sur une distance relativement grande. Il y a plusieurs raisons à cela. Premièrement, il y a la question de la tolérance de fabrication des pistes d'alimentation 32 et des plages de connexion 34. Deuxièmement, les supports flexibles 6 et 8 sont généralement formés d'un matériau pouvant être quelque peu déformé, de manière élastique ou de manière plastique. Troisièmement, lors de l'assemblage à chaud des supports flexibles 6 et 8 à la cellule électro-optique 4, des tensions thermo-mécaniques sont engendrées, pouvant notamment conduire à une certaine dilatation ou déformation des supports flexibles 6 et 8.

Pour résoudre ce problème notamment, il est prévu selon l'invention au moins une partie intermédiaire lâche formée dans le présent mode de réalisation par un pli 42. A la figure 1, il est prévu trois parties intermédiaires lâches, à savoir trois plis 42 pour chacun des supports flexibles 6 et 8.

Chaque pli 42 est situé entre deux ensembles de plages de connexion électrique 34. De plus, dans le cas présent, chaque pli est situé entre deux ensembles de plages de connexion électrique 34 associés respectivement à deux unités actives 26 adjacentes. Sur la figure 1, à chaque unité active 26 correspond trois circuits intégrés 16. Ainsi, pour l'adressage de deux unités actives 26 adjacentes, trois circuits intégrés 16 sur le support flexible 6 et trois circuits intégrés 16 sur le support flexible 8 sont nécessaires. Les plis 42 sont répartis avec une périodicité prédéterminée dont la valeur correspond sensiblement à la largeur occupée par deux unités actives 26 adjacentes.

On notera que les plis sont libres, c'est-à-dire qu'ils ne sont pas fixés directement à la plaque de verre 20 au moyen de la colle conductrice anisotrope 38 prévue dans le présent mode de réalisation. Dans une variante de réalisation, les pistes métallisées dans les régions intermédiaires lâches sont recouvertes d'une couche de protection pour éviter tout court-circuit dans les plis. Grâce à l'agencement des plis 42 le long de chaque support flexible 6 et 8, il est possible d'aligner les extrémités des pistes d'alimentation 32 avec les ensembles de plages de connexion électrique 34 par segment ou partie lors de la fabrication du module électro-optique compris dans le dispositif d'affichage selon l'invention. La colle 38 peut être déposée initialement soit sur la plaque 20, soit sur le support flexible 6 ou 8. De plus, cette colle peut être déposée sur toute la longueur du support flexible ou seulement le long des segments 44 situés entre les parties intermédiaires lâches 42.

Dans le présent mode de réalisation, les tolérances lors de l'assemblage doivent permettre l'alignement des pistes électriques 36 reliées à trois circuits intégrés 16 qui se suivent et qui sont associés à deux unités actives 26 adjacentes. On comprend que la différence maximale entre l'écartement des deux pistes extrêmes des pistes d'alimentation 32 associées aux deux plages de connexion extrêmes d'un ensemble de plages de connexion 34 se trouvant dans un segment 44 définis par deux plis 42 est la même dans la fabrication d'un module électro-optique selon l'invention que la différence maximale tolérée entre les deux pistes d'alimentation extrêmes 32 d'une cellule 4 et des deux plages de connexion correspondantes situées aux deux extrémités du support flexible dans une réalisation qui ne comprendrait pas de parties intermédiaires lâches.

Selon une caractéristique supplémentaire de l'invention, les parties 48 des pistes métallisées 14 qui sont situées dans les régions respectives des parties intermédiaires lâches 42 présente un écartement supérieur à l'écartement de ces mêmes pistes métallisées 14 dans les régions situées entre ces parties intermédiaires lâches 42, c'est-à-dire dans les segments 44.

De plus, la largeur des parties 48 des pistes métallisées 14 présente une largeur supérieure dans les régions des parties intermédiaires lâches 42 que dans les régions des segments 44. Grâce à cet agencement, il est possible d'assembler un connecteur 10 au support flexible 6 ou 8 dans les parties lâches d'extrémité 50. Pour ce faire, le support flexible 6, respectivement 8 est sectionné de telle manière que les parties 48 des pistes 14 sont situées dans les deux régions d'extrémité de chaque support flexible 6 et 8.

Sur la figure 5 est représenté un support flexible 6' qui correspond au support flexible 6, après l'agencement des circuits intégrés 16 mais avant son assemblage à la cellule électro-optique 4. Le support flexible 6' fait également l'objet de la présente invention. Ce support flexible 6' présente des pistes métallisées 14 servant à relier les circuits intégrés 16 à une unité d'alimentation d'un dispositif d'affichage électro-optique. Ce support 6' comprend également des pistes 36 de connexion électrique des circuits intégrés 16 à des unités actives de cellules électro-optiques.

L'agencement des pistes métallisées et des circuits intégrés 16 définis des parties intermédiaires 42' entre des parties 44' où sont agencés des ensembles de plage de connexion électrique 34 et également les circuits intégrés 16. Dans les parties intermédiaires 42', les parties 48 des pistes métallisées 14 situées dans ces parties intermédiaires présentent un écartement supérieur à l'écartement de ces pistes métallisées dans les parties 44'. Les parties 48 des pistes métallisées 14 présentent une largeur supérieure à la largeur de ces pistes métallisées 14 dans les régions des parties 44'.

Comme cela a déjà été mentionné ci-avant, l'agencement des parties intermédiaires 42' permet, après sectionnement transversal du support flexible 6', d'agencer un connecteur conventionnel aux deux extrémités résultantes du support flexible 6' sectionné. Ce connecteur permet d'établir une liaison électrique entre chaque piste métallisée 14 et une alimentation électrique d'un dispositif d'affichage selon l'invention.

Ainsi, chaque région intermédiaire 42' peut servir à l'agencement d'un connecteur ou à la formation d'une partie intermédiaire lâche, tel un pli, comme cela a été décrit ci-avant. De ce fait, il est possible de produire le support flexible 6' sous la forme d'une bande continue et de fabriquer plusieurs modules d'affichage électro-optique à l'aide d'un seul support flexible 6' se présentant initialement sous la forme d'une bande.

De plus, grâce aux caractéristiques de l'invention, il est possible de fabriquer à partir du même support flexible 6' en forme de bande divers modules d'affichage électro-optique ayant des dimensions différentes, en particulier un nombre d'unités actives différent. Ainsi, à l'aide du même support flexible 6', il est possible de fabriquer dans le mode de réalisation de la figure 1 des modules d'affichage électro-optique ayant un nombre pair quelconque d'unités actives 26.

On remarquera que le nombre de circuits intégrés et le nombre de plages de connexion électrique 34 par segment 44, respectivement 44' peuvent être quelconque.

Finalement, on notera que, dans une variante du mode de réalisation décrit à l'aide des figures 1 à 4, un seul support flexible 6 peut être prévu en lieu et place des deux supports flexibles 6 et 8 représentés à la figure 1.

## Revendications

1. Dispositif d'affichage électro-optique comportant au moins un module d'affichage (2) comprenant un ensemble électro-optique (4) qui comprend au moins deux unités actives (26) et des moyens d'alimentation (6, 8, 10, 12 et 16) de cet ensemble électro-optique, **caractérisé en ce que** lesdits moyens d'alimentation comprennent un support flexible allongé (6, 8) sur lequel des pistes métallisées (14, 36) de connexion électrique sont agencées pour relier lesdites au moins deux unités actives à une unité d'alimentation (12) desdits moyens d'alimentation, ce support flexible allongé étant assemblé audit ensemble électro-optique et présentant au moins une partie intermédiaire lâche (42) située entre deux ensembles de plages de connexion électrique (34) reliées électriquement à des pistes d'alimentation (32) desdites unités actives (26).

2. Dispositif d'affichage selon la revendication 1, **caractérisé en ce que** ladite partie intermédiaire lâche (42) est formée par un pli dudit support flexible (6, 8).

3. Dispositif d'affichage selon la revendication 2, **caractérisé en ce que** ledit module d'affichage comprend une plaque en verre (20) sur le bord de laquelle est fixé ledit support flexible (6, 8), ledit pli (42) étant libre.

4. Dispositif d'affichage selon l'une des revendications précédentes, **caractérisé en ce que** ledit support flexible allongé (6, 8) présente plusieurs parties intermédiaires lâches (42) réparties avec une périodicité prédéterminée et séparant des ensembles de plages de connexion électrique (34) entre ledit support flexible (6, 8) et ledit ensemble électro-optique (4).

5. Dispositif d'affichage selon l'une des revendications précédentes, **caractérisé en ce que** des circuits intégrés (16) sont agencés sur ledit support flexible (6, 8), ces circuits intégrés étant reliés électriquement auxdites pistes métallisées (14, 36).

6. Dispositif d'affichage selon l'une des revendications précédentes, **caractérisé en ce que** ledit support flexible (6, 8) est formé par un matériau en polyester ou en polyimide.

7. Dispositif d'affichage selon la revendication 4, **caractérisé en ce que** les parties desdites pistes métallisées (14) situées dans les régions respectives desdites plusieurs parties intermédiaires lâches (42) présentent un écartement supérieur à l'écartement de ces pistes métallisées entre lesdites plusieurs parties intermédiaires lâches.

8. Dispositif d'affichage selon la revendication 7, **caractérisé en ce que** lesdites parties (48) desdites pistes métallisées (14), situées dans les régions respectives desdites plusieurs parties intermédiaires lâches (42), présentent une largeur supérieure à la largeur de ces pistes métallisées entre les plusieurs parties intermédiaires lâches.

9. Support flexible (6') pour dispositifs d'affichage électro-optique servant à relier électriquement au moins deux unités actives (26), d'au moins un ensemble électro-optique (4), à une unité d'alimentation (12), de ce dispositif d'affichage, ce support flexible étant allongé et ayant sur au moins une de ses surfaces des pistes métallisées (14) s'étendant selon la direction longitudinale dudit support flexible et destinées à être connectées électriquement à ladite unité d'alimentation, ce support flexible (6') présentant des parties intermédiaires (42'), entre des parties de connexion (44') de ce support flexible où sont agencés des ensembles de plages de connexion électrique (34), dans lesquelles lesdites pistes métallisées (14) présentent un écartement supérieur à l'écartement de ces pistes métallisées (14) dans lesdites parties de connexion (44').

10. Support flexible selon la revendication 9, dans lequel lesdites pistes métallisées (14) dans lesdites parties intermédiaires (42') présentent une largeur supérieure à la largeur de ces pistes métallisées dans lesdites parties de connexion électrique (44').

11. Support flexible selon la revendication 9 ou 10 dans lequel chaque partie intermédiaire (42') est susceptible d'être sectionné transversalement pour permettre l'agencement d'un connecteur à l'une ou l'autre des deux extrémités résultantes.

12. Support flexible selon l'une des revendications 9 à 11 qui se présente sous la forme d'une bande continue destinée à être sectionnée lors de la fabrication de dispositifs d'affichage électro-optique de manière à obtenir des tronçons de longueur quelconque prédéterminée destinés à autant de modules électro-optiques formant ces dispositifs d'affichage.

13. Support flexible selon l'une des revendications 9 à 12 supportant des circuits intégrés (16) reliés électriquement aux pistes métallisées (14, 36).

## Patentansprüche

1. Elektrooptische Anzeigevorrichtung, die wenigstens ein Anzeigemodul (2) umfaßt, das eine elektrooptische Baueinheit (4) mit wenigstens zwei aktiven Einheiten (26) und Versorgungsmittel (6, 8, 10, 12 und 16) für diese elektrooptische Baueinheit umfaßt, **dadurch gekennzeichnet, daß** die Versorgungsmittel einen langgestreckten flexiblen Träger (6, 8) umfassen, auf dem metallisierte elektrische Verbindungsbahnen (14, 36) angeordnet sind, um die wenigstens zwei aktiven Einheiten mit einer Versorgungseinheit (12) der Versorgungsmittel zu verbinden, wobei dieser langgestreckte flexible Träger an die elektrooptische Baueinheit angefügt ist und wenigstens einen spannungslosen Zwischenabschnitt (42) aufweist, der sich zwischen zwei Gesamtheiten elektrischer Anschlußflächen (34) befindet, die mit den Versorgungsbahnen (32) der aktiven Einheiten (26) elektrisch verbunden sind.

2. Anzeigevorrichtung nach Anspruch 1, **dadurch gekennzeichnet, daß** der spannungslose Zwischenabschnitt (42) durch eine Falte des flexiblen Trägers (6, 8) gebildet ist.

3. Anzeigevorrichtung nach Anspruch 2, **dadurch gekennzeichnet, daß** das Anzeigemodul eine Glasplatte (20) umfaßt, an deren Rand der flexible Träger (6, 8) befestigt ist, wobei die Falte (42) frei ist.

4. Anzeigevorrichtung nach einem der vorhergehenden Ansprüche, **dadurch gekennzeichnet, daß** der langgestreckte flexible Träger (6, 8) mehrere spannungslose Zwischenabschnitte (42) aufweist, die mit einer vorgegebenen Periodizität verteilt sind und die Gesamtheiten elektrischer Anschlußflächen (34) zwischen dem flexiblen Träger (6, 8) und der elektrooptischen Baueinheit (4) trennen.

5. Anzeigevorrichtung nach einem der vorhergehenden Ansprüche, **dadurch gekennzeichnet, daß** auf dem flexiblen Träger (6, 8) integrierte Schaltungen (16) angeordnet sind, die mit den metallisierten Bahnen (14, 36) elektrisch verbunden sind.

6. Anzeigevorrichtung nach den vorhergehenden Ansprüchen, **dadurch gekennzeichnet, daß** der flexible Träger (6, 8) aus einem Polyester- oder Polyaamid-Werkstoff gebildet ist.

7. Anzeigevorrichtung nach Anspruch 4, **dadurch gekennzeichnet, daß** die Abschnitte der metallisierten Bahnen (14), die sich in den entsprechenden Bereichen der mehreren spannungslosen Zwischenabschnitte (42) befinden, einen Abstand aufweisen, der größer als der Abstand dieser metallisierten Bahnen zwischen den mehreren spannungslosen Zwischenabschnitten ist.

8. Anzeigevorrichtung nach Anspruch 7, **dadurch gekennzeichnet, daß** die Abschnitte (48) der metallisierten Bahnen (14), die sich in den entsprechenden Bereichen der mehreren spannungslosen Zwischenabschnitte (42) befinden, eine Breite aufweisen, die größer als die Breite dieser metallisierten Bahnen zwischen den mehreren spannungslosen Zwischenabschnitten ist.

9. Flexibler Träger (6') für elektrooptische Anzeigevorrichtungen, der dazu dient, wenigstens zwei aktive Einheiten (26) wenigstens einer elektrooptischen Baueinheit (4) mit einer Versorgungseinheit (12) dieser Anzeigevorrichtung zu verbinden, wobei dieser flexible Träger langgestreckt ist und auf wenigstens einer seiner Oberflächen metallisierte Bahnen (14) aufweist, die sich in der Längsrichtung des flexiblen Trägers erstrecken und dazu bestimmt sind, mit der Versorgungseinheit elektrisch verbunden zu werden, wobei dieser flexible Träger (6') zwischen den Anschlußabschnitten (44') dieses flexiblen Trägers, wo Gesamtheiten elektrischer Anschlußflächen (34) angeordnet sind, Zwischenabschnitte (42') aufweist, in denen die metallisierten Bahnen (14) einen Abstand aufweisen, der größer als der Abstand dieser metallisierten Bahnen (14) in den Anschlußabschnitten (44') ist.

10. Flexibler Träger nach Anspruch 9, bei dem die metallisierten Bahnen (14) in den Zwischenabschnitten (42') eine Breite aufweisen, die größer als die Breite dieser metallisierten Bahnen in den elektrischen Anschlußabschnitten (44') ist.

11. Flexibler Träger nach Anspruch 9 oder 10, bei dem jeder Zwischenabschnitt (42') in Querrichtung unterteilt sein kann, um die Anordnung eines Verbinders an dem einen oder dem anderen der beiden sich ergebenden Enden zu ermöglichen.

12. Flexibler Träger nach einem der Ansprüche 9 bis 11, der die Form eines ununterbrochenen Bandes besitzt, das dazu bestimmt ist, bei der Herstellung elektrooptischer Anzeigevorrichtungen unterteilt zu werden, derart, daß Teilstücke mit einer beliebigen, vorgegebenen Länge erhalten werden, die für ebensoviele elektrooptische Module bestimmt sind, die diese Anzeigevorrichtungen bilden.

13. Flexibler Träger nach einem der Ansprüche 9 bis 12, der integrierte Schaltungen (16) trägt, die mit den metallisierten Bahnen (14, 36) elektrisch verbunden sind.

## Claims

1. Electro-optical display device comprising at least one display module (2) including one electro-optical assembly (4) which includes at least two active units (26) and means (6, 8, 10, 12 and 16) for supplying said electro-optical assembly, **characterised in that** the supply means comprise an elongated flexible support (6, 8) on which metallized electric connection tracks (14, 36) are arranged to connect said at least two active units to a supply unit (12) of the supply means, said elongated flexible support being assembled to the electro-optical assembly and having at least one loose intermediate portion (42) situated between two sets of electric connection pads (34) electrically connected to supply tracks (32) of said active units (26).

2. Display device according to claim 1, **characterised in that** said loose intermediate portion (42) consists of a fold of said flexible support (6, 8).

3. Display device according to claim 2, **characterised in that** said display module comprises a glass plate (20) on the edge of which is fixed said flexible support (6, 8), said fold (42) being free.

4. Display device according to any of the preceding claims, **characterised in that** said elongated flexible support (6, 8) has several loose intermediate portions (42) distributed with predetermined periodicity and separating sets of electric cohnection pads (34) between said flexible support (6, 8) and said electro-optical assembly (4).

5. Display device according to any of the preceding claims, **characterised in that** integrated circuits (16) are arranged on said flexible support (6, 8), said integrated circuits being electrically connected to said metallized tracks (14, 36).

6. Display device according to any of the preceding claims, **characterised in that** said flexible support (6, 8) consists of a polyester or polyimide material.

7. Display device according to claim 4, **characterised in that** the portions of said metallized tracks (14) situated in the respective regions of said several loose intermediate portions (42) have a greater spacing than that of said metallized tracks between said several loose intermediate portions.

8. Display device according to claim 7, **characterised in that** said portions (48) of said metallized tracks (14), situated in the respective regions of said several loose intermediate portions (42), have a greater width than that of said metallized tracks between the several loose intermediate portions.

9. Flexible support (6') for electro-optical display devices used to connect electrically at least two active units (26) of at least one electro-optical assembly (4) to a supply unit (12) of said display device, said flexible support being elongated and having on at least one of its surfaces metallized tracks (14) which extend along the longitudinal direction of said flexible support and are intended to be electrically connected to said supply unit, said flexible support (6') having intermediate portions (42'), between connection portions (44') of said flexible support where sets of electric connection pads (34) are arranged, wherein said metallized tracks (14) have a spacing greater than the spacing of such metallized tracks (14) in said electric connection portions (44').

10. Flexible support according to claim 9, wherein said metallized tracks (14) in said intermediate portions (42') have a greater width than that of said metallized tracks in said electric connection portions (44').

11. Flexible support according to claim 9 or 10, wherein each intermediate portion (42') is capable of being cut in a transverse direction to allow the arrangement of a connector to one or other of the two resulting ends.

12. Flexible support according to any of claims 9 to 11, which has the form of a continuous strip intended to be cut during manufacturing of electro-optical display devices so as to obtain sections of any predetermined length intended for as many electro-optical modules forming such display devices.

13. Flexible support according to any of claims 9 to 12 carrying integrated circuits (16) electrically connected to the metallized tracks (14, 36).
